# EUROPÄISCHE PATENTSCHRIFT

(11) **EP 1 245 139 B1**
(45) Veröffentlichungstag und Bekanntmachung des Hinweises auf die Patenterteilung: **17.09.2003**
(21) Anmeldenummer: 00990516.7
(22) Anmeldetag: 11.12.2000
(51) Int. Cl.: H05K 7/14

(54) **BETÄTIGUNGSELEMENT ZUM EIN- UND AUSHEBELN VON FLACHBAUGRUPPEN MIT VERRIEGELUNGSSCHIEBER, FRONTELEMENT FÜR EINE FLACHBAUGRUPPE MIT BETÄTIGUNGSELEMENT UND BAUGRUPPENTRÄGER ZUR AUFNAHME VON FLACHBAUGRUPPEN**
ACTUATOR ELEMENT FOR LEVERING IN AND OUT PRINTED CIRCUIT MODULES WITH LOCKING SLIDE, FRONT ELEMENT FOR A PRINTED CIRCUIT MODULE WITH ACTUATOR ELEMENT, AND SUBRACK THAT RECEIVES PRINTED CIRCUIT MODULES
ELEMENT D'ACTIONNEMENT POURVU D'UN CURSEUR DE VERROUILLAGE POUR FAIRE ENTRER ET SORTIR PAR UN MOUVEMENT DE LEVIER DES MODULES PLATS, ELEMENT FRONTAL POUR MODULE PLAT AVEC ELEMENT D'ACTIONNEMENT ET SUPPORT DE MODULES DESTINE A RECEVOIR DES MODULES PLATS

(30) Priorität: 23.12.1999 DE 29922725 U
(43) Veröffentlichungstag der Anmeldung: 02.10.2002
(73) Patentinhaber: Rittal Electronic Systems GmbH & Co. KG, 90542 Eckental (DE)
(72) Erfinder: KÖRBER, Werner, 91282 Betzenstein (DE); KURRER, Siegfried, 90449 Nürnberg (DE); SCHAFFER, Kurt-Michael, 90542 Eckental (DE)
(74) Vertreter: Fleck, Hermann-Josef, Dr.-Ing.
(86) Internationale Anmeldenummer: DE0004400
(87) Internationale Veröffentlichungsnummer: WO01049091

(56) Entgegenhaltungen:
- EP-A- 0 330 957
- WO-A-96/42187
- WO-A-98/34449
- DE-U- 29 823 122
- US-A- 5 940 276

## Beschreibung

Die Erfindung betrifft ein Betätigungselement, womit Flachbaugruppen, welche elektronische Schaltungen tragen, ohne großen Kraftaufwand in ein Trägersystem eingehebelt bzw. daraus wieder entnommen werden können. Derartige Betätigungselemente werden seit längerem eingesetzt und sind in unterschiedlichen Ausführungen bekannt. In der Europäischen Patentschrift EP 0 330 957 B1 ist beispielhaft eine weit verbreitete Ausführung für ein solches Betätigungselement dargestellt. Dieses wird als Steck- und Ziehhilfe bezeichnet, und ist Bestandteil eines Frontsystems für Steckbaugruppen, die in einen Baugruppenträger einschiebbar sind. Die Steck- und Ziehhilfe weist einen Hebel auf, der an einem Endstück drehbar gelagert ist. Eine Bedienpersonen kann die Steck- und Ziehhilfe über den Hebel betätigen und durch entsprechende Schwenkung eine Ein- bzw. Aushebelung der Steckbaugruppe bewirken. Zur Erzielung dieser Bewegungen weist der Hebel eine Nut auf, deren außenliegende Kanten als Nasen gestaltet sind. Diese stützen sich bei einer Ein- oder Aushebelbewegung an entsprechenden Kanten des Baugruppenträgers ab, insbesondere an Querverbindungsschienen des Baugruppenträgers.

In besonderen Anwendungsfällen können Flachbaugruppen, die in einen Baugruppenträger eingesteckt sind, besonderen Belastungen ausgesetzt sein, die auf ungünstigen Umgebungsbedingungen beruhen können. So können z.B. Rüttelmomente von außen auf einen Baugruppenträger aufgebracht werden. In einem solchen Fall ist es nicht vollkommen ausgeschlossen, dass sich Flachbaugruppen, die in den Baugruppenträger eingesteckt sind, lösen und die elektrischen Kontakte an deren Steckverbindern zumindest teilweise unterbrochen werden. Zur Vermeidung dieser Problematik ist es bekannt, die an einem Frontsystem einer Flachbaugruppe angebrachten Hebelziehgriffe verrastbar auszuführen. In der Internationalen Patentanmeldung mit der Veröffentlichungsnummer WO 98/34449 ein Frontsystem für Leiterplatten beschrieben, welches derart verrastbare Hebelziehgriffe aufweist. Im Inneren des dortigen Hebelziehgriffes ist ein Rastschieber gelagert, der den Hebelziehgriff und damit das Frontsystem und die damit ausgerüstete Flachbaugruppe in einer in den Baugruppenträger eingeschobenen Position verrastet und sichert. Eine Entsicherung und die Eröffnung der Möglichkeit einer Entnahme, d.h. Aushebelung, der Flachbaugruppe aus dem Baugruppenträger ist erst nach einer Betätigung des integrierten Rastschiebers möglich. Dabei tritt das Problem auf, dass zur Entriegelung des Rastschiebers eine Druckkraft von oben auf den Hebelziehgriff ausgeübt werden muss. Dies ist ergonomisch ungünstig und kann eine schnelle, ungehinderte Betätigung des Hebelziehgriffs einschränken.

Eine ähnliche Anordnung ist im Deutschen Gebrauchsmuster DE 298 23 122 U1 beschrieben. In den dortigen Ein- und Aushebelgriff ist ein zusätzlicher, federbetätigter Riegel integriert. Dieser verrastet den Ein- und Aushebegriff in einer hinteren Endstellung der Steckbaugruppe, die dem in einen Baugruppenträger eingeschobenen Zustand entspricht. Bei dieser Anordnung wird der Riegel auch dazu benutzt, um ein in den Ein- und Aushebegriff integriertes Schaltelement zu betätigen oder freizugeben. Dieses Schaltelement wird für eine sogenannte Aktiv-Passiv-Schaltung der Steckbaugruppe eingesetzt. Dabei wird bei einer Betätigung des Riegels die Steckbaugruppe passiv geschaltet. Auch bei dieser Anordnung tritt das Problem auf, dass die Betätigung des Riegels eine von oben auszuübende Druckkraft erfordert. Dies ist ergonomisch ungünstig und kann eine schnelle, ungehinderte Betätigung des Hebelziehgriffs einschränken.

Der Erfindung liegt die Aufgabe zugrunde, insbesondere ein Betätigungselement für Flachbaugruppen, in das ein federbetätigter Riegel integriert ist, so weiter auszugestalten, dass dieses einfacher zu bedienen ist.

Die Aufgabe wird gelöst mit dem in Anspruch 1 angegebenen Betätigungselement. Weitere vorteilhafte Ausführungsformen des Betätigungselements sind in den Unteransprüchen angegeben. Weitere Unteransprüche betreffen ein Frontsystem für eine Flachbaugruppe, welche mit mindestens einem Betätigungselement gemäß der Erfindung ausgerüstet ist, betreffen ferner eine Flachbaugruppe mit einem entsprechenden Frontsystem, und betreffen schließlich einen Baugruppenträger mit einem entsprechenden Frontsystem.

Das erfindungsgemäße Betätigungselement weist auf ein Endstück, welches zur Verbindung mit einer Flachbaugruppe vorbereitet ist und einen Betätigungshebel. Der Betätigungshebel ist drehbar am Endstück gelagert und weist zumindest auf ein Griffteil und einen Verriegelungsschieber, der zwischen zumindest zwei Schaltstellungen verschiebbar ist. Dabei hält der Verriegelungsschieber den Betätigungshebel in einer ersten Schaltstellung in einer ersten Position, welche einem eingehebelten Zustand der Flachbaugruppe entspricht, und gibt den Betätigungshebel in einer zweiten Schaltstellung frei.

Eine derartige Ausführung weist den besonderen Vorteil auf, dass eine Bedienung eines auf der Oberseite des Griffteils zugänglichen Verriegelungsschiebers erheblich vereinfacht ist.

Die Erfindung wird an Hand der nachfolgend kurz angegebenen Figuren näher erläutert. Dabei zeigt
- Figur 1:: eine perspektivische Seitenansicht auf eine prinzipielle Ausführung eines Betätigungselementes gemäß der Erfindung, und
- Figur 2:: eine seitliche Draufsicht auf ein Frontsystem für eine Flachbaugruppe mit einem Betätigungselementes gemäß der Erfindung.

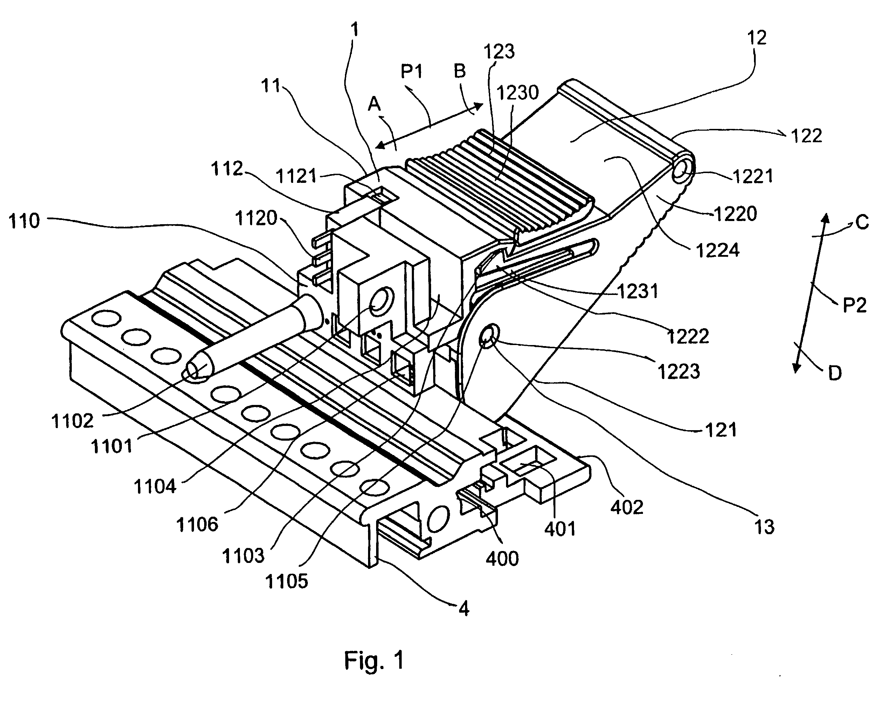

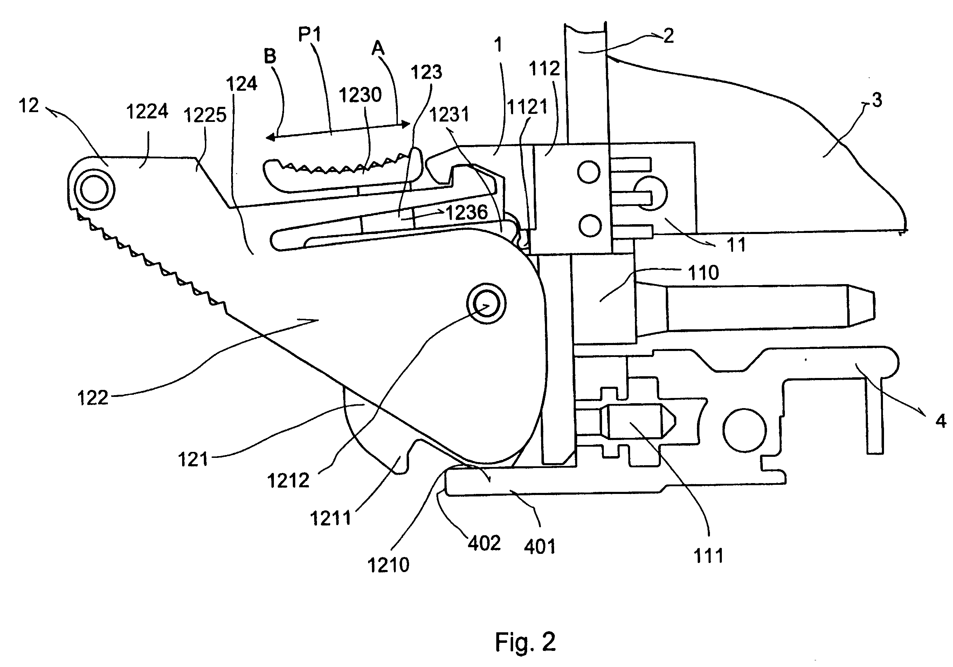

Die Figuren 1 und 2 zeigt in Seitenansichten jeweils eine Ausführung eines zum Ein- und/oder Aushebeln einer Flachbaugruppe 3 dienenden Betätigungselementes 1 gemäß der Erfindung. Es weist als Grundelemente ein Endstück 11 auf, welches zur Verbindung mit einer Flachbaugruppe vorbereitet ist, und einen Betätigungshebel 12, der drehbar am Endstück 11 gelagert ist. Erfindungsgemäß weist der Betätigungshebel 12 zumindest auf ein Griffteil 122 und einen Verriegelungsschieber 123. Dieser ist zwischen zumindest zwei Schaltstellungen A und B verschiebbar. In einer ersten Schaltstellung A wird der Betätigungshebel 12 in einer ersten Position C gehalten, welche einem eingehebelten Zustand der Flachbaugruppe 3 entspricht. Diese Position ist in den Figuren 1 und 2 dargestellt. Demgegenüber wird der Betätigungshebel 12 in einer zweiten Schaltstellung B vom Verriegelungsschieber 123 freigegeben. Der Betätigungshebel 12 kann dann in eine zweite Position D schwenken bzw. geschwenkt werden. Eine solche gekippte Stellung kann dem aus einem Baugruppenträger ausgehebelten Zustand der Flachbaugruppe 3 entsprechen. In Figur 1 sind die Positionen C und D des Betätigungshebels 12 durch einen Pfeil P2 und die Schaltstellungen A und B durch einen Pfeil P1 dargestellt.

Es ist vorteilhaft, wenn der Betätigungshebel 12 zusätzlich ein Ein- und/oder Aushebelstück 121 aufweist, welches zumindest teilweise aus einem verschleißfesten Material besteht. Dieses ist mit dem Griffteil 122 verbunden und weist vorteilhaft sowohl eine Einhebelnase 1210 als auch eine Aushebelnase 1211 auf. Das Ein- und/oder Aushebelstück 121 stützt sich am Baugruppenträger ab, um eine Ein- bzw. Aushebelung der Flachbaugruppe 3 zu bewirken. Bei den in den Figuren 1 und 2 dargestellten Beispielen ist beispielhaft eine untere Querverbindungsschiene 4 als ein Teil eines Baugruppenträgers gezeigt. Diese weist eine Lochschiene 401 mit einer Reihe von Eingriffslöchern auf. Bei einer Einhebelung stützt sich die Einhebelnase 1210, wie in Figur 2 dargestellt, in einem Eingriffsloch der Lochschiene 401 ab, während bei einer Aushebelung die Aushebelnase 1211 sich auf der Stirnseite 402 der Lochschiene 401 abstützt.

Das Endstück 11 des Betätigungselements 1, welches beispielhaft in einer perspektivischen Rückansicht in der Figur 1 und in einer Seitenansicht in der Figur 2 zu sehen ist, weist im Kern einen Tragkörper 110 auf. Dieser weist eine Bohrung 1101 auf, welche zur Befestigung mit einer Flachbaugruppe 3 z.B. über eine Schraube dienen kann. Das Endstück 11 verfügt desweiteren über einen Kontaktpin 1102, der bei Einschub einer mit einem entsprechenden Betätigungselement 1 versehenen Flachbaugruppe in einen Baugruppenträger eine Massekontaktierung zwischen den Elementen bewirkt. Zur Halterung einer in einen Baugruppenträger eingeschobenen Einheit z.B. aus einer Flachbaugruppe mit einem angebrachten Frontsystem, welches aus einer Frontplatte und bevorzugt zwei Betätigungselementen 1 an den Enden besteht, kann im Tragkörper 110 eine Halteschraube 111 vorgesehen sein, welche in eine Quernut 400 der Querverbindungsschiene 4 eingreifen kann. Vorteilhaft weist der Tragkörper 110 eine Bohrung 1105 auf. In diese kann eine Drehwelle 13 eingebracht werden, worüber der Betätigungshebel 12 drehbar am Tragkörper 110 gehalten werden kann. Die Drehwelle 13 kann gleichzeitig auch in einer Bohrung 1212 eines zusätzlichen Ein- und Aushebelstückes 121 liegen. In diesem Fall sind alle Teile des Betätigungshebels 12 über die Drehwelle 13 mit dem Endstück 11 verbunden. Ferner ist vorteilhaft eine Haltenut 1104 zum Einschub des unteren Endes einer ausschnittsweise dargestellten Frontplatte 2 vorhanden. Schließlich weist der Tragkörper 110 an einer dem Betätigungshebel 12 zugewandten Seite eine Rastnase 1103 auf. In diese kann eine entsprechende, bevorzugt federnde Rastlamellen 1222 des Betätigungshebels 12 eingreifen, wenn dieser sich in der eingerasteten Position befindet.

Ferner kann in das Endstück 11 des Betätigungselements 1 ein Schaltelement 112 integriert sein, insbesondere ein Mikroschalter. Die Funktion eines derartigen Schaltelements 112 ist im Europäischen Patent EP 0 832 547 beschrieben. Vorteilhaft sind der Verriegelungsschieber 123 und das Schaltelement 112 so aufeinander abgestimmt, dass der Verriegelungsschieber 123 in der ersten Schaltstellung A auch das Schaltelement 112 aktiviert.

Der im Beispiel der Figur 1 dargestellte Betätigungshebel 12 des Betätigungselements 1 weist erfindungsgemäß ein Griffteil 122 und ein Ein- und/oder Aushebelstück 121 auf. Dabei weist das Griffteil 122 eine Bohrung 1223, das Ein- und/oder Aushebelstück 121 eine Bohrung 1212 und das Endstück 11 eine Bohrung 1105 auf. Eine Drehwelle 13 kann durch alle Bohrungen so hindurch geführt werden, dass der Betätigungshebel 12 drehbar am Endstück 11 gelagert ist. Mit Hilfe der Drehung kann eine Einhebelung einer mit dem Endstück verbundenen Flachbaugruppe 3 in einen Baugruppenträger bzw. eine Aushebelung aus dem Baugruppenträger bewirkt werden.

Das Griffteil 122 weist einen Griffkopf 1220 auf, der einen händischen Zugriff einer Bedienperson ermöglicht. Mittels der zusätzlichen Querbohrung 1221 am vorderen Ende des Griffkopfes 1220 können nebeneinander liegende Griffteile 122 von mehreren Betätigungselementen, die an verschiedenen Flachbaugruppen angebracht sind, mechanisch so miteinander verbunden werden, dass eine synchrone Bewegung derselben möglich ist. Figur 1 zeigt das Griffteil 122 in einer Position, welche dem in einen Baugruppenträger eingehebelten Zustand der Flachbaugruppe 3 entspricht. Zusätzlich ist das Griffteil 122 mit dem Endstück 11 in dieser Position mit Hilfe von Verrastmitteln verrastet, in dem eine federnde Rastlamelle 1222 des Griffteils 122 eine Rastnase 1103 des Endstücks 11 hintergreift. Über eine integrierte, in Figur 1 nicht dargestellte Rückstellfeder 14 wird der Betätigungshebel 12 in die in Figur 1 dargestellte Ruheposition zurück bewegt, wenn keine nach unten gerichtete Kraft auf das Griffteil 122 ausgeübt wird.

Erfindungsgemäß weist der Verriegelungsschieber 123 des Betätigungselements 1 einen Bedienschieber 1230 auf, der auf dem Griffteil 122, auf dessen Oberseite 1224, verschiebbar ist. Eine derartige Anordnung bietet für eine Bedienperson eine gute Griffsicherheit bei der Handhabung des Betätigungshebels. Ferner ist ein auf der Oberseite 1224 eines Griffkopfes 1220 des Griffteiles 122 befindlicher Bedienschieber 1230 sehr gut handhabbar, d.h. dessen unterschiedliche Schaltpositionen für eine Bedienperson schnell und sicher einstellbar.

Die Ergonomie kann weiter verbessert werden, wenn das Griffteil 122 gemäß der in Figur 2 dargestellten Ausführung auf einer Außenseite, insbesondere der Oberseite 1224 eine Mulde 1225 aufweist, in welcher der Bedienschieber 1230 quasi in einer versenkten Position befindlich und verschiebbar ist. Besonders vorteilhaft ist der Bedienschieber 1230 möglichst flach, weist auf der Außenseite eine Mulde auf, welche mit einer Rippung versehen werden kann.

Zur Aktivierung eines integrierten Schaltelements 112 weist der Verriegelungsschieber 123 vorteilhaft zusätzlich einen in das Griffteil 122 integrierten Schaltschieber 1231 auf. Figur 2 zeigt den Zustand, indem der Schaltschieber 1231 den Schaltbügel 1121 des Schaltelements 112 betätigt. Vorteilhaft sind der Bedienschieber 1230 und der Schaltschieber 1231 des Verriegelungsschiebers 123 annähernd vertikal zur Verschieberichtung A-B angeordnet und über eine Verbindungssäule 1236 miteinander verbunden. Schließlich weist der Betätigungshebel 12 vorteilhaft integrierte Federmittel 124 auf, die auf den Verriegelungsschieber 123 eine Schubkraft ausüben, welche auf die erste Schaltstellung A gerichtet ist. In der Darstellung von Figur 2 hat dies zur Folge, dass auf den Verriegelungsschieber 123 eine Vorspannung ausgeübt wird, die auf den Tragkörper 110 des Endstücks 11 und insbesondere den an dieser Stelle vorstehenden Schaltbügel 1121 des Schaltelements 112 gerichtet ist.

## Patentansprüche

1. Betätigungselement (1) zum Ein- und Aushebeln einer Flachbaugruppe (3), welches aufweist
a) ein Endstück (11), welches zur Verbindung mit einer Flachbaugruppe (3) vorbereitet ist, und
b) einen Betätigungshebel (12), der drehbar am Endstück (11) gelagert ist und zumindest aufweist
b1) ein Griffteil (122) und
b2) einen Verriegelungsschieber (123), der zwischen zumindest zwei Schaltstellungen (A,B) verschiebbar ist, und der
b22) in einer ersten Schaltstellung (A) den Betätigungshebel (12) in einer ersten Position (C) hält, welche einem eingehebelten Zustand der Flachbaugruppe (3) entspricht, und der
b23) in einer zweiten Schaltstellung (B) den Betätigungshebel (12) freigibt, wobei
der Verriegelungsschieber (123) einen Bedienschieber (1230) aufweist, der auf dem Griffteil (122) verschiebbar ist,
**dadurch gekennzeichnet,**
**dass** der Bedienschieber (1230) auf der Oberseite (1224) des Griffteils (122) verschiebbar ist.

2. Betätigungselement (1) nach Anspruch 1,
**dadurch gekennzeichnet,**
**dass** das Griffteil (122) auf einer Außenseite eine Mulde (1225) aufweist, in welcher der Bedienschieber (1230) verschiebbar ist.

3. Betätigungselement (1) nach einem der Ansprüche 1 oder 2,
**dadurch gekennzeichnet,**
**dass** der Bedienschieber (1230) flach ist.

4. Betätigungselement (1) nach einem der Ansprüche 1 bis 3,
**dadurch gekennzeichnet,**
**dass** der Bedienschieber (1230) auf der Außenseite eine Mulde aufweist.

5. Betätigungselement (1) nach einem der Ansprüche 1 bis 4,
**dadurch gekennzeichnet,**
**dass** der Bedienschieber (1230) auf der Außenseite eine Rippung aufweist.

6. Betätigungselement (1) nach einem der vorangegangenen Ansprüche,
**dadurch gekennzeichnet,**
**dass**
a) ein Schaltelement (112), insbesondere ein Mikroschalter, in das Endstück (11) integriert ist, und
b) der Verriegelungsschieber (123) in der ersten Schaltstellung (A) das Schaltelement (112) aktiviert.

7. Betätigungselement (1) nach Anspruch 6,
**dadurch gekennzeichnet, dass** der Verriegelungsschieber (123) für die Aktivierung des Schaltelementes (112) einen in das Griffteil (122) integrierten Schaltschieber (1231) aufweist.

8. Betätigungselement (1) nach einem der Ansprüche 1 bis 7,
**dadurch gekennzeichnet,**
**dass**
a) ein Schaltelement (112) in das Endstück (11) integriert ist, insbesondere ein Mikroschalter, und der Verriegelungsschieber (123) für die Aktivierung des Mikroschalters (112) in der ersten Schaltstellung (A) einen in das Griffteil (122) integrierten Schaltschieber (1231) aufweist, und
b) der Bedienschieber (1230) und der Schaltschieber (1231) des Verriegelungsschiebers (123) annähernd vertikal zur Verschieberichtung (A-B) angeordnet und über eine Verbindungssäule (1236) miteinander verbunden sind.

9. Betätigungselement (1) nach einem der vorangegangenen Ansprüche,
**dadurch gekennzeichnet,**
**dass** der Betätigungshebel (12) Federmittel (124) aufweist, die auf den Verriegelungsschieber (123) eine Schubkraft ausüben, welche auf die erste Schaltstellung (A) gerichtet ist.

10. Betätigungselement (1) nach einem der vorangegangenen Ansprüche,
**dadurch gekennzeichnet,**
**dass** das Griffteil (122) zusätzlich ein Ein- und Aushebelstück (121) aufweist, welche zumindest teilweise aus einem verschleißfesten Material besteht (Fig. 2).

11. Betätigungselement (1) nach Anspruch 10,
**dadurch gekennzeichnet,**
**dass** ein Ein- und Aushebelstück (121) zumindest eine Ein- und Aushebelnase (1210, 1211) aus einem verschleißfesten Material aufweist.

12. Betätigungselement (1) nach einem der vorangegangenen Ansprüche,
**dadurch gekennzeichnet,**
**dass** das Griffteil (122) des Betätigungshebels (12) aus einem ergonomisch gut formbaren Material besteht, insbesondere aus Kunststoff.

13. Betätigungselement (1) nach einem der vorangegangenen Ansprüchen
**dadurch gekennzeichnet,**
**dass** das Endstück (11) und das Griffteil (122) des Betätigungshebels (12) jeweils eine Bohrung (1105; 1223) aufweisen und über eine eingelegte Drehwelle (13) miteinander verbunden sind.

14. Betätigungselement (1) nach Anspruch 10 oder 11,
**dadurch gekennzeichnet,**
**dass** das Endstück (11) das Ein- und Aushebelstück (121) und das Griffteil (122) des Betätigungshebels (12) jeweils eine Bohrung (1105, 1212, 1223) aufweisen und über eine eingelegte Drehwelle (13) miteinander verbunden sind.

15. Frontsystem für eine Flachbaugruppe (3), welches aufweist eine Frontplatte (2) und mindestens ein Betätigungselement (1) nach einem der vorangegangenen Ansprüche 1 bis 14, das an einem Ende der Frontplatte (2) angebracht ist.

16. Flachbaugruppe mit einem Frontsystem nach Anspruch 15.

17. Baugruppenträger (4), welcher so gestaltet ist, dass Flachbaugruppen (3) mit einem Frontsystem nach Anspruch 15 ein- und aushebelbar sind.

## Claims

1. Actuating element (1) for levering a printed circuit board (3) in and out, the actuating element having
a) an end piece (11), which is prepared for connection to a printed circuit board (3), and
b) an actuating lever (12) which is mounted in a rotatable manner on the end piece (11) and has, at least,
b1) a grip part (122) and
b2) a locking slide (123), which can be displaced between at least two switching positions (A, B) and which,
b22) in a first switching position (A), retains the actuating lever (12) in a first position (C), corresponding to a levered-in state of the printed circuit board (3), and which,
b23) in a second switching position (B), releases the actuating lever (12), it being the case that
the locking slide (123) has an operating slide (1230) which can be displaced on the grip part (122),
**characterized in that** the operating slide (1230) can be displaced on the top side (1224) of the grip part (122).

2. Actuating element (1) according to Claim 1, **characterized in that**, on an outer side, the grip part (122) has a hollow (1225) in which the operating slide (1230) can be displaced.

3. Actuating element (1) according to either of Claims 1 and 2, **characterized in that** the operating slide (1230) is flat.

4. Actuating element (1) according to one of Claims 1 to 3, **characterized in that** the operating slide (1230) has a hollow on the outer side.

5. Actuating element (1) according to one of Claims 1 to 4, **characterized in that** the operating slide (1230) has ribbing on the outer side.

6. Actuating element (1) according to one of the preceding claims, **characterized in that**
a) a switching element (112), in particular a microswitch, is integrated in the end piece (11), and
b) the locking slide (123) activates the switching element (112) in the first switching position (A).

7. Actuating element (1) according to Claim 6, **characterized in that**, for activating the switching element (112), the locking slide (123) has a switching slide (1231) integrated in the grip part (122).

8. Actuating element (1) according to one of Claims 1 to 7, **characterized in that**
a) a switching element (112), in particular a microswitch, is integrated in the end piece (11), and the locking slide (123), for activating the microswitch (112) in the first switching position (A), has a switching slide (1231) integrated in the grip part (122), and
b) the operating slide (1230) and the switching slide (1231) of the locking slide (123) are arranged more or less perpendicularly to the displacement direction (A-B) and are connected to one another via a connecting column (1236).

9. Actuating element (1) according to one of the preceding claims, **characterized in that** the actuating lever (12) has resilient means (124) which subject the locking slide (123) to a pushing force in the direction of the first switching position (A).

10. Actuating element (1) according to one of the preceding claims, **characterized in that** the grip part (122), in addition, has a levering-in and levering-out member (121) which consists, at least in part, of a wear-resistant material (Figure 2).

11. Actuating element (1) according to Claim 10, **characterized in that** a levering-in and levering-out member (121) has at least one levering-in and levering-out nose (1210, 1211) made of a wear-resistant material.

12. Actuating element (1) according to one of the preceding claims, **characterized in that** the grip part (122) of the actuating lever (12) consists of a material which lends itself well to ergonomic shaping, in particular of plastic.

13. Actuating element (1) according to one of the preceding claims, **characterized in that** the end piece (11) and the grip part (122) of the actuating lever (12) each have a bore (1105; 1223) and are connected to one another via a rotary shaft (13) positioned therein.

14. Actuating element (1) according to Claim 10 or 11, **characterized in that** the end piece (11), the levering-in and levering-out member (121) and the grip part (122) of the actuating lever (12) each have a bore (1105, 1212, 1223) and are connected to one another via a rotary shaft (13) positioned therein.

15. Front system for a printed circuit board (3), which has a front panel (2) and at least one actuating element (1) according to one of the preceding Claims 1 to 14, which is fitted at one end of the front panel (2).

16. Printed circuit board with a front system according to Claim 15.

17. Mounting rack (4) which is configured such that printed circuit boards (3) with a front system according to Claim 15 can be levered in and out.

## Revendications

1. Elément d'actionnement (1) pour faire entrer et sortir par un mouvement de levier un module plat (3), présentant :
a) un élément frontal (11) préparé en vue du raccordement à un module plat (3), et
b) un levier d'actionnement (12) monté à rotation sur l'élément frontal (11), et présentant au moins
b1) un élément de préhension (122) et
b2) un curseur de verrouillage (123) pouvant coulisser entre au moins deux positions de contact (A, B), et qui
b22) maintient, dans une première position de contact (A), le levier d'actionnement (12) dans une première position (C) correspondant à celle du module plat (3) engagé par le mouvement de levier, et qui
b23) libère, dans une seconde position de contact (B), le levier d'actionnement (12),
le curseur de verrouillage (123) présentant un curseur de manipulation (1230), qui est coulissant sur l'élément de préhension (122),
**caractérisé en ce que**
le curseur de manipulation (1230) est coulissant sur la face supérieure (1224) de l'élément de préhension (122).

2. Elément d'actionnement (1) suivant la revendication 1,
**caractérisé en ce que**
l'élément de préhension (122) présente, sur une face extérieure, un enfoncement (1225) dans lequel peut coulisser le curseur de manipulation (1230).

3. Elément d'actionnement (1) suivant l'une des revendications 1 ou 2,
**caractérisé en ce que**
le curseur de manipulation (1230) est plat.

4. Elément d'actionnement (1) suivant l'une des revendications 1 à 3,
**caractérisé en ce que**
le curseur de manipulation (1230) présente un enfoncement sur la face extérieure.

5. Elément d'actionnement (1) suivant l'une des revendications 1 à 4,
**caractérisé en ce que**
le curseur de manipulation (1230) présente un ensemble de cannelures sur la face extérieure.

6. Elément d'actionnement (1) suivant l'une des revendications qui précèdent,
**caractérisé en ce que**
a) un élément de contact (112), en particulier un microrupteur, est intégré à l'élément frontal (11), et
b) le curseur de verrouillage (123) active, dans la première position de contact (A), l'élément de contact (112).

7. Elément d'actionnement (1) suivant la revendication 6,
**caractérisé en ce que**
le curseur de verrouillage (123) présente un curseur de contact (1231) intégré à l'élément de préhension (122) en vue de l'activation de l'élément de contact (112).

8. Elément d'actionnement (1) suivant l'une des revendications 1 à 7,
**caractérisé en ce que**
a) un élément de contact (112) est intégré à l'élément frontal (11), en particulier un microrupteur, et **en ce que** le curseur de verrouillage (123) présente un curseur de contact (1231) intégré à l'élément de préhension (122) en vue de l'activation du microrupteur (112) dans la première position de contact (A), et
b) le curseur de manipulation (1230) et le curseur de contact (1231) du curseur de verrouillage (123) sont placés à peu près verticalement par rapport à la direction de translation (A-B) et sont raccordés par une barre de raccordement (1236).

9. Elément d'actionnement (1) suivant l'une des revendications qui précèdent,
**caractérisé en ce que**
le levier d'actionnement (12) présente des moyens faisant ressort (124) qui exercent une force de poussée sur le curseur de verrouillage (123) qui est dirigée sur la première position de contact (A).

10. Elément d'actionnement (1) suivant l'une des revendications qui précèdent,
**caractérisé en ce que**
l'élément de préhension (122) présente en outre une pièce d'engagement et de dégagement par effet de levier (121), laquelle se compose au moins partiellement de matière résistant à l'usure (fig. 2).

11. Elément d'actionnement (1) suivant la revendication 10,
**caractérisé en ce**
**qu'**une pièce d'engagement et de dégagement par effet de levier (121) présente au moins un busc d'engagement et de dégagement par effet de levier (1210, 1211) en matière résistant à l'usure.

12. Elément d'actionnement (1) suivant l'une des revendications qui précèdent,
**caractérisé en ce que**
l'élément de préhension (122) du levier d'actionnement (12) est fait dans une matière à bonne aptitude au formage du point du vue ergonomique, en particulier de matière plastique.

13. Elément d'actionnement (1) suivant l'une des revendications qui précèdent,
**caractérisé en ce que**
l'élément frontal (11) et l'élément de préhension (122) du levier d'actionnement (12) présentent un alésage (1105 ; 1223) et sont solidarisés par un axe de rotation (13) emmanché.

14. Elément d'actionnement (1) suivant la revendication 10 ou 11,
**caractérisé en ce que**
l'élément frontal (11), la pièce d'engagement et de dégagement par effet de levier (121) et l'élément de préhension (122) du levier d'actionnement (12) présentent tous un alésage (1105, 1212, 1223) et sont solidarisés par un axe de rotation (13) emmanché.

15. Système frontal pour un module plat (3), système présentant une plaque frontale (2) et au moins un élément d'actionnement (1) suivant l'une des revendications qui précèdent 1 à 14, placé à une extrémité de la plaque frontale (2).

16. Module plat avec un système frontal suivant la revendication 15.

17. Support de module (4), conçu de façon à ce que des modules plats (3) comprenant un système frontal suivant la revendication 15 puissent être engagés et dégagés par effet de levier.
